Europäisches Patentamt

European Patent Office

Office européen des brevets

(11) Veröffentlichungsnummer: **0 178 465**
**A1**

# (12) EUROPÄISCHE PATENTANMELDUNG

(21) Anmeldenummer: 85111609.5

(22) Anmeldetag: 13.09.85

(51) Int. Cl.⁴: **H 05 K 7/20**

(30) Priorität: 04.10.84 DE 3436407

(43) Veröffentlichungstag der Anmeldung:
23.04.86 Patentblatt 86/17

(84) Benannte Vertragsstaaten:
AT BE CH FR GB IT LI LU NL SE

(71) Anmelder: Autz + Herrmann
Karl-Benz-Strasse 10-12
D-6900 Heidelberg 1(DE)

(72) Erfinder: Reinhard, Heinrich
Hans-Pfitzner-Strasse 28
D-6905 Schriesheim(DE)

(74) Vertreter: Rüger, Rudolf, Dr.-Ing. et al,
Webergasse 3 Postfach 348
D-7300 Esslingen/Neckar(DE)

(54) Einschub-Kühlgerät für Schaltschränke.

(57) Ein Einschub-Kühlgerät für zur Aufnahme von Modul-Einschüben eingerichtete Schaltschränke weist ein im wesentlichen parallelflächig begrenztes Einschubgehäuse (1) auf, in dem ein von einem Innenluftstrom und einem Außenluftstrom durchströmter durchströmter gemeinsamer Wärmetauscher angeordnet ist.

Um die Handhabung und Fertigung dieses Einschub-Kühlgerätes zu vereinfachen, ist die Anordnung derart getroffen, daß auf das Einschubgehäuse (1) im Bereiche der seitlich angeordneten Gehäuseöffnungen (42) Luftleitelemente (500) aufgesetzt sind, durch die die Richtung der Luftströme des Innenluftkreislaufs wahlweise einstellbar ist.

./...

Fig. 1

- 1 -

Einschub-Kühlgerät für Schaltschränke

Die Erfindung betrifft ein Einschub-Kühlgerät für zur Aufnahme von Modul-Einschüben eingerichtete staub- oder spritzwassergeschützte Schaltschränke, mit einem im wesentlichen parallelflächig begrenzten Einschubgehäuse, das an seiner Vorderseite einen Außenluftauslaß und einen Außenlufteinlaß aufweist und in dem ein von einem Innenluftstrom und einem Außenluftstrom durchströmter gemeinsamer Wärmetauscher angeordnet ist, wobei der Innen- und der Außenluftstrom in dem Einschubgehäuse voneinander getrennt geführt und beiden Luftströmen in dem Einschubgehäuse untergebrachte Gebläse zugeordnet sind, der Wärmetauscher aus einer Anzahl zu einem abgeschlossenen Plattenpaket zusammengefügter gleicher Platten besteht, zwischen denen abwechselnd von der Innen- und der Außenluft durchströmte flache Kanäle begrenzt sind und das Plattenpaket im wesentlichen der Einschubhöhe entsprechende Höhenabmessungen aufweist und in dem Einschubgehäuse seitlich des Plattenpaketes dem Innenluftstrom zugeordnete Luftkanäle angeordnet sind, die über Gehäuseöffnungen und Luftleitmittel mit dem Schaltschrankinneren in Verbindung setzbar sind.

Dieses Einschub-Kühlgerät nach der DE-A-34 05 243 gestattet es, bei staubdicht abgeschlossenen Schaltschränken eine einwandfreie Wärmeabfuhr in unmittelbarer Nähe der jeweiligen Wärmequellen zu gewährleisten. Die Gehäuseöffnungen für den Innenluftstrom sind in der Ober-, Unter-, Seiten- oder Stirnwand des Einschubgehäuses angeordnet und wahlweise verschließbar ausgebildet. Die Strömungsrichtung des Innenluftstromes in dem Schaltschrank kann dadurch zweckentsprechend eingestellt werden, daß jeweils zweckdienliche Gehäuseöffnungen verschlossen bzw. offen gelassen werden, wobei die Luftumlenkung durch in entsprechenden Luftkammern angebrachte Luftleitbleche zusammen mit der jeweils verschlossenen Gehäuseöffnung erfolgt.

Soll das Plattenpaket nach längerer Betriebszeit gereinigt werden, so wird dieses Einschub-Kühlgerät, das auf Teleskopschienen in dem Schaltschrank gelagert ist, herausgezogen, worauf nach Abschrauben des nun frei zugänglichen Gehäusedeckels das lösbar in das Gehäuse eingesetzte Plattenpaket herausgehoben werden kann.

Aufgabe der Erfindung ist es, die Fertigung und die Handhabung dieses Einschub-Kühlgerätes weiter zu vereinfachen.

Zur Lösung dieser Aufgabe ist das eingangs genannte Einschub-Kühlgerät gemäß der Erfindung dadurch ge- kennzeichnet, daß nur die Rückwand und die Seiten- wände des Einschubgehäuses Gehäuseöffnungen auf- weisen, auf die Luftleitelemente aufgesetzt sind, durch die allein die Richtung der Luftströme des Innenluftkreislaufs wahlweise einstellbar ist.

Damit brauchen an dem Gehäuse lediglich noch seitliche Gehäuseöffnungen für den Innenluftstrom vorgesehen zu werden, was eine beträchtliche Verein-

- 3 -

0178465

fachung der Herstellung bedeutet, da - verglichen mit dem eingangs erwähnten Einschub-Kühlgerät - weniger Gehäuseöffnungen mit zugeordneten Verschlußeinrichtungen erforderlich sind. Gleichzeitig ist auch die Handhabung des Gerätes vereinfacht, weil die jeweils gewünschte Strömungsrichtung des Innenluftstroms durch zweckdienliche Orientierung der in dem Gehäuse befestigten Luftleitelemente eingestellt werden kann.

In diesem Zusammenhang ist zu erwähnen, daß aus der DD-PS 147 182 es bekannt ist, bei einer einen als kompakte Baueinheit ausgeführten Wärmeaustauscher aufweisenden Anordnung zur Wärmeabführung aus Schalt- und Steuerschränken aufsteckbare Luftleit- elemente vorzusehen. Bei dieser Anordnung handelt es sich aber nicht um ein Einschub-Kühlgerät. Außerdem sind diese Luftleitelemente in Gestalt von Saugdüsen ausgebildet, die an dem Wärmeaustauscher angeordnet und in dem Schalt- oder Steuerschrank auf Wärmequellen mit besonders hoher Wärmeverlustleistung gerichtet sind, um die Wärme zielgerichtet abzuziehen.

Die Befestigung der Luftleitelemente an dem Gehäuse kann an sich in jeder zweckentsprechenden Weise geschehen; besonders einfache Verhältnisse ergeben sich, wenn die Luftleitelemente auf das Gehäuse aufgesteckt, d.h. mit diesem verrastet sind. Die Luftleitelemente selbst sind mit Vorteil durch im Querschnitt im wesentlichen U-förmig gebogene Luftleitbleche oder -bögen gebildet, die aus Metallblech oder Kunststoffmaterial bestehen.

Eine weitere Vereinfachung der Handhabung des Gerätes kann dadurch erzielt werden, wenn das Plattenpaket in das Gehäuse von der Vorderseite her einschiebbar ist und die den Einlaß und den Auslaß für den Außenluftstrom enthaltende Gehäusevorderwand abnehmbar oder abklappbar ausgebildet ist.

In der Zeichnung ist ein Ausführungsbeispiel der Erfindung dargestellt. Es zeigen:

Fig. 1 ein Einschub-Kühlgerät in einer
    Draufsicht,

Fig. 2 das Einschub-Kühlgerät nach Fig. 1, in einer
    Seitenansicht, und

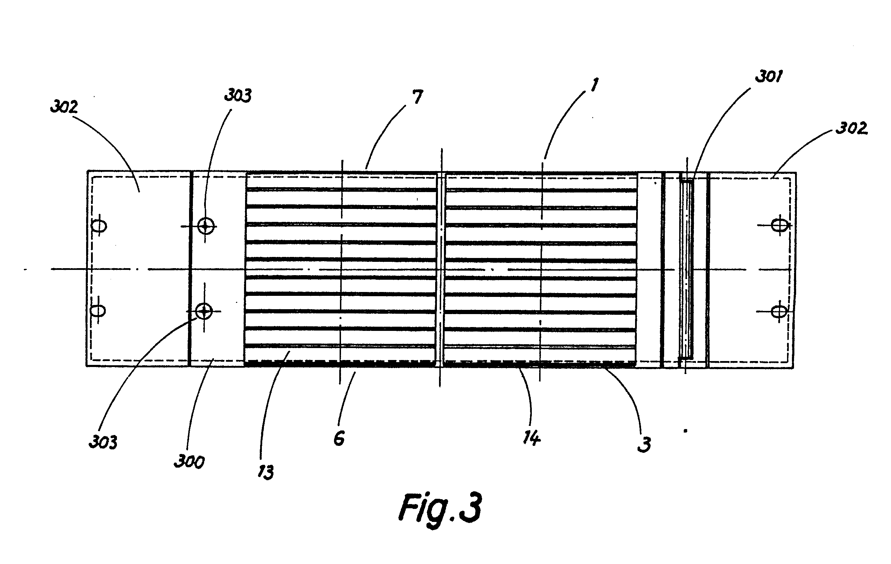

Fig. 3 das Einschub-Kühlgerät nach Fig. 1, in einer
    Ansicht von vorne.

Das Einschub-Kühlgerät weist ein im Querschnitt rechteckiges, flaches Einschubgehäuse 1 auf, das in Gestalt eines Blechgehäuses ausgebildet ist und dessen Außenabmessungen entsprechend dem Modul des zur Aufnahme von Modul-Einschüben eingerichteten Schaltschrankes gewählt sind. In der Praxis weit verbreitet sind bei diesen sogenannten Intermaß-Schaltschränken die 19"-Einschübe.

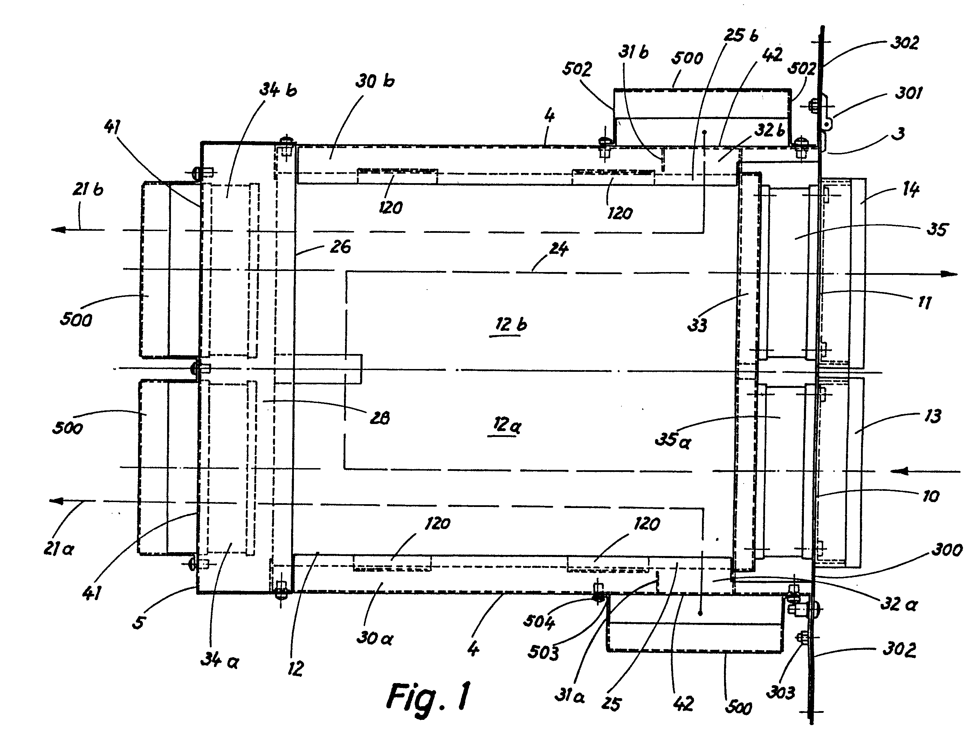

Das parallelflächig begrenzte Einschubgehäuse 1 besteht aus einer gegebenenfalls Handgriffe tragenden Vorderwand 3, zwei Seitenwänden 4, einer Rückwand 5, einer Bodenwand 6 und einem gegebenenfalls in Gestalt eines lösbaren Deckels ausgebildeten Deckwand 7. In der Vorderwand 3 sind nebeneinanderliegend eine Einlaßöffnung 10 und eine Auslaßöffnung 11 für einen Außenluftstrom vorgesehen, der ein in dem Einschubgehäuse 1 untergebrachtes, eine Wärmetauscher-Einrichtung bildendes Plattenpaket 12 auf einem im wesentlichen U-förmigen Strömungsweg 24 (Fig. 1) durchströmt. Auf der Vorderwand 3 sind im Bereiche der Einlaß- und der Auslaßöffnung 10
bzw. 11 verstellbare Luftleiteinrichtungen in Gestalt drehbar gelagerter Jalousien 13,14 angeordnet.

Das in Innern des Einschubgehäuses 1 angeordnete
Plattenpaket besteht aus zwei Teilplattenpaketen
12a, 12b, von denen jedes aus einer Anzahl miteinander verklebter gleicher Platten 17 zusammengesetzt
ist, die jeweils mit hochgebogenen seitlichen Rändern und einem an der Stirnseite hochgebogenen
Rand versehen sind. Der genaue Aufbau dieser
Platten 17 und deren gegenseitige Zuordnung sind
in der DE-PS 30 45 326 beschrieben.

Zwischen den Platten 17 sind jeweils flache
Kanäle 20 begrenzt, die bei jedem Teilplattenpaket 12a von einem Teilluftstrom 21a bzw. 21b
durchströmt sind, der im Inneren des Schaltschrankes
im Kreislauf geführt ist (Innenluftkreislauf).

Die abwechselnd zwischen den mit der Innenluft
beaufschlagten Kanälen 20 liegenden, von
den Platten begrenzten Kanäle des aus den beiden
Teilplattenpaketen 12a, 12b bestehenden Plattenpaketes 12 sind von dem Außenluftstrom durchströmt; über die Platten hinweg ergibt sich ein
kurzer Wärmeaustauschweg zwischen dem Innen-
und dem Außenluftstrom.

Die beiden Innen-Teilluftströme 21a, 21b treten
in die Kanäle 20 der Teilplattenpakete 12a,
12b auf der der Vorderwand 3 abgewandten Stirnseite ein. Die zugeordneten Luftauslässe sind
in der Nähe der Vorderwand 3 auf gegenüberliegenden Seiten des Plattenpaketes 12 angeordnet und
mit 25a bzw. 25b bezeichnet.

In dem Einschubgehäuse 1 ist durch eine in der Nähe der Gehäuserückwand 5 angeordnete Trennwand 26 eine gegebenenfalls quer unterteilte Kammer 28 abgeteilt, die mit seitlich des Plattenpaketes 12 sich erstreckenden Luftkanälen 30a, 30b in Verbindung steht, die endseitig durch Wände 31a bzw.31b gegen ebenfalls seitlich des Plattenpaketes 12 angeordnete Luftkanäle 32a, 32b abgedichtet ist, in die ihrerseits die Innenluft-Auslässe 25a, 25b des Plattenpaketes 12 münden.

In der Kammer 28 sind zwei Axialgebläse 34a, 34b angeordnet, die die Teilluftströme 21a, 21b erzeugen. Zur Erzeugung des Außenluftstroms dient ein Axialgebläse 35, das abgedichtet zwischen einer einen entsprechenden Luftdurchlaß aufweisenden Trennwand 33 und der Vorderwand 3 angeordnet ist. Erforderlichenfalls kann zwischen der Vorderwand 3 und der Trennwand 33 noch ein zweites Axialgebläse 35a angeordnet sein, das eine Leistungssteigerung durch Erhöhung der Luftgeschwindigkeit zu erzielen gestattet.

Das Plattenpaket 12 ist in das Einschubgehäuse 1 lösbar eingesetzt. Es ist stirnseitig zwischen den beiden Trennwänden 26, 33 abgedichtet gehaltert und seitlich an Führungsstücken 120 längsverschieblich geführt. Die Vorderwand 3 weist einen den Innenraum des Einschubgehäuses 1 abdeckenden Teil 300 auf, der mittels eines Scharnieres 301 um eine vertikale Scharnierachse schwenkbar an den seitlich sich erstreckenden, an den Gehäuseseitenwänden 4 befestigten Vorderwandteilen 302 schwenkbar befestigt ist. In der in Fig. 1 dargestellten Betriebsstellung ist der Vorderwandteil 300 auf der dem Scharnier 301 gegenüberliegenden Seite mit dem zugeordneten Vorderwandteil 302 über Schrauben 303 lösbar verbunden.

Um das Plattenpaket zu reinigen, braucht nach dem Lösen der Schrauben 303 lediglich der Vorderwandteil 300 um die Achse des Scharniers 301 abgeschwenkt zu werden. Da das Gebläse 35 und die Jalousien 13,14 sowie die Trennwand 33 mit diesem Vorderwandteil 300 verbunden sind, wird damit das Plattenpaket 12 von der Einzugsgehäuse-Vorderseite her frei zugänglich, während das Einschubgehäuse 1 selbst in dem Schaltschrank verbleibt. Irgendwelche Teleskopschienen oder dergl. Einrichtungen zur Herausnahme des Einschubgehäuses 1 aus dem Schaltschrank entfallen somit.

In der Gehäuserückwand 5 sind den Axialgebläsen 34a, 34b zugeordnete Gehäuseöffnungen 41 vorgesehen, die nebeneinanderliegend angeordnet sind. Entsprechend sind in den beiden Gehäuseseitenwänden 4 in der Nähe der Vorderwand 3 zwei Gehäuseöffnungen 42 ausgebildet, die mit den Luftkanälen 32a, 32b in Verbindung stehen.

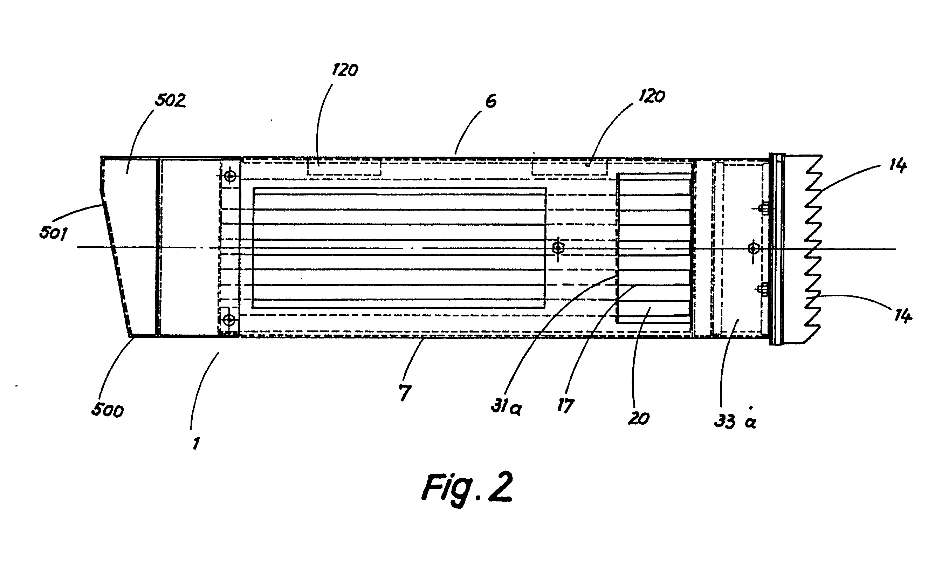

Im Bereiche der Gehäuseöffnungen 41,42 sind auf die Gehäuserückwand 5 bzw. die Gehäuseseitenwände 4 Luftleitelemente 500 aufgesetzt, die aus etwa L-förmig gestalteten Luftleitflächen 501 (Fig.2) und seitlichen Abschlußwänden 502 (Fig. 1) bestehen und die mittels seitlicher Flansche 503 und Befestigungsschrauben 504 an den jeweiligen Gehäusewänden befestigt sind. Anstelle der Befestigungsschrauben 504 können die Luftleitelemente 500 auch mit angeformten Rastelementen ausgebildet sein, mit denen sie an der Berandung der Gehäuseöffnungen 41,42 formschlüssig verrastet sind.

Die im wesentlichen bogenförmigen Luftleitelemente 500 gestatten es, die Teilluftströme 21a, 21b des

**0178465**

Innenluftkreislaufes wahlweise nach oben oder
nach unten zu richten - abhängig davon, mit
welcher Orientierung ihrer Ein- bzw. Ausströmöffnung die Luftleitelemente 5 an dem Einschubgehäuse 1 befestigt sind. Da sie in ihrer Höhenabmessung nicht die Höhenabmessung des Einschubgehäuses 1 übersteigen, kann dieses ohne bauliche
Veränderungen an dem Schaltschrank in der bekannten
Weise in den Schaltschrank eingesetzt werden.

0178465

Patentansprüche:

1. Einschub-Kühlgerät für zur Aufnahme von Modul-Einschüben eingerichtete staub- oder spritzwassergeschützte Schaltgeräte, mit einem im wesentlichen parallelflächig begrenzten Einschubgehäuse, das an seiner Vorderseite einen Außenluftauslaß und einen Außenlufteinlaß aufweist und in dem ein von einem Innenluftstrom und einem Außenluftstrom durchströmter gemeinsamer Wärmetauscher angeordnet ist, wobei der Innen- und der Außenluftstrom in dem Einschubgehäuse voneinander getrennt geführt und beiden Luftströmen in dem Einschubgehäuse untergebrachte Gebläse zugeordnet sind, der Wärmetauscher aus einer Anzahl zu einem abgeschlossenen Plattenpaket zusammengefügter gleicher Platten besteht, zwischen denen abwechselnd von der Innen- und der Außenluft durchströmte flache Kanäle begrenzt sind und das Plattenpaket im wesentlichen der Einschubhöhe entsprechende Höhenabmessungen aufweist und in dem Einschubgehäuse seitlich des Plattenpaketes dem Innenluftstrom zugeordnete Luftkanäle angeordnet sind, die über Gehäuseöffnungen und Luftleitmittel mit dem Schaltschrankinneren in Verbindung setzbar sind, dadurch gekennzeichnet, daß nur die Rückwand (5) und die Seitenwände (4) des Einschubgehäuses (1) Gehäuseöffnungen (41, 42) aufweisen, auf die Luftleitelemente (500) aufgesetzt sind, durch die allein die Richtung der Luftströme (21a, 21b) des Innenluftkreislaufs wahlweise einstellbar ist.

2. Einschub-Kühlgerät nach Anspruch 1, dadurch gekennzeichnet, daß die Luftleitelemente (500) auf das Einschubgehäuse (1) aufgesteckt sind.

**0178465**

3. Einschub-Kühlgerät nach Anspruch 1 oder 2, dadurch gekennzeichnet, daß die Luftleitelemente (500) durch im Querschnitt im wesentlichen L-förmig gebogene Luftleitbleche (501) oder -bögen gebildet sind.

4. Einschub-Kühlgerät nach einem der vorhergehenden Ansprüche, dadurch gekennzeichnet, daß das Plattenpaket (12) in das Einschubgehäuse (1) von der Vorderseite her einschiebbar ist und die den Einlaß und den Auslaß (10, 11) enthaltende Gehäusevorderwand (3; 300) abnehmbar oder abklappbar ausgebildet ist.

**Fig. 1**

0178465

Fig. 2

Fig.3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| A,D | EP-A-0 152 093 (AUTZ + HERRMANN) <br> * Seite 3, Zeile 21 - Seite 4, Zeile 12 * | 1 | H 05 K 7/20 |
| A | NEW ELECTRONICS, Band 17, Nr. 14, Juli 1984, Seiten 47-49, Warley, West Midlands, GB; K. REYNOLDS: "Cooling systems in 19-inch cabinets" <br> * Insgesamt * | 1 | |
| A,D | DD-A- 147 182 (BRAUNER) <br> * Figur 2 * | 1 | |
| A,D | DE-A-3 045 326 (AUTZ + HERRMANN) <br> * Seite 7, Absatz 2 - Seite 8, Absatz 1 * | 1 | RECHERCHIERTE SACHGEBIETE (Int Cl 4) <br><br> H 05 K <br> F 24 F |

Der vorliegende Recherchenbericht wurde für alle Patentansprüche erstellt.

| Recherchenort <br> DEN HAAG | Abschlußdatum der Recherche <br> 13-01-1986 | Prüfer <br> TOUSSAINT F.M.A. |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82